# EUROPÄISCHE PATENTSCHRIFT

(11) **EP 0 663 108 B1**
(45) Veröffentlichungstag und Bekanntmachung des Hinweises auf die Patenterteilung: **27.12.1996**
(21) Anmeldenummer: 93919009.6
(22) Anmeldetag: 16.09.1993
(51) Int. Cl.: H01R 23/66, H01R 13/74

(54) **KONTAKTIERVORRICHTUNG ZUM ANSCHLUSS EINER MEHRERE KONTAKTLEITERBAHNEN AUFWEISENDEN LEITERFOLIE**
CONTACTING DEVICE FOR A FILM WITH SEVERAL CONDUCTOR TRACKS
DISPOSITIF DE CONTACT POUR LE RACCORDEMENT D'UN FILM CONDUCTEUR PRESENTANT PLUSIEURS PISTES CONDUCTRICES DE CONTACT

(30) Priorität: 29.09.1992 DE 4232622
(43) Veröffentlichungstag der Anmeldung: 19.07.1995
(73) Patentinhaber: Siemens Nixdorf Informationssysteme Aktiengesellschaft, 33102 Paderborn (DE)
(72) Erfinder: DUBOIS, Dieter, D-86199 Augsburg (DE); WANDINGER, Franz, D-81825 München (DE)
(74) Vertreter: Fuchs, Franz-Josef, Dr.-Ing.
(86) Internationale Anmeldenummer: DE9300873
(87) Internationale Veröffentlichungsnummer: WO9408366

(56) Entgegenhaltungen:
- EP-A- 0 284 855
- DE-C- 3 108 858
- GB-A- 2 212 007
- US-A- 4 191 441
- US-A- 4 556 264

## Beschreibung

Die Erfindung betrifft eine Kontaktiervorrichtung nach den Merkmalen des Oberbegriffs des Anspruchs 1.

Im Schaltungsaufbau elektronischer Geräte sind nicht nur die geometrischen Gegebenheiten des die Schaltung aufnehmenden Gehäuses,sondern vielfach auch unterschiedliche Technologien bei einzelnen Bauelementen und Baugruppen zu berücksichtigen. Diesen unterschiedlichen Anforderungen kommt beispielsweise ein modularer Aufbau sehr entgegen, selbst dann, wenn es sich um dem Wesen nach einheitliche und zusammengehörige Funktionskomplexe handelt, weil die eine oder andere Schaltungskomponente im Bedarfsfall leicht abgetrennt bzw. gegen eine andere gleichartige oder geänderte Baugruppe ausgetauscht werden kann. Außerdem können je nach der bei den einzelnen Baugruppen eingesetzten Technologie unterschiedliche Fertigungsverfahren eingesetzt werden.

Dieser modulare Aufbau hat aber bekanntlich auch zur Folge, daß an den Verbindungsstellen der einzelnen Baugruppen und Funktionseinheiten Kontaktiervorrichtungen und gegebenenfalls Leitungsverbindungen vorhanden sein müssen.

Um dem damit verbundenen Aufwand an Mehrfachsteckverbindungen zu begegnen, wird beispielsweise bei Leiterplatten die Steckerleiste eingespart und durch parallel an eine Außenkante herausgeführte Leiterbahnen ersetzt, die unmittelbar mit den Kontaktfedern einer aufsteckbaren Federleiste kontaktiert werden können. Von dort führt dann ein mit der Federleiste verbundenes Kabel zu Steckeranschlüssen einer anderen Baugruppe oder an den externen Gerätestecker.

Eine weitere Maßnahme zur Kostenverringerung besteht darin, das Kabel einer der Baugruppen zuzuordnen und an dieser direkt, d.h. ohne lösbare Steckverbindung zu befestigen. Allerdings ist für die direkte Anbindung eines Kabels an eine Baugruppe ein hoher fertigungstechnischer Aufwand erforderlich, der oft die Kosten der eingesparten Steckverbindung aufwiegt. Bei Leiterfolien, die eine flexible, einem Kabel ähnliche Leiterführung ermöglichen, lassen sich die Funktionen von Leiterplatte und Kabel zwar in idealer Weise vereinen, weil ein Teil der Leiterfolie mit parallelen Leiterbahnen, die vorzugsweise in einen Laschenansatz der Leiterfolie münden, ausgestattet werden kann, so daß dieser Teil die Funktion eines Anschlußkabels übernimmt. Schwierigkeiten bereitet dagegen die anschließende Kontaktierung mit einem Stecker, weil der flexible Laschenansatz das kraftschlüssige Aufstecken einer Federleiste im Gegensatz zu einer starren Steckerleiste deutlich erschwert.

Es ist deshalb bereits eine Vorrichtung mit einer den Laschenansatz bogenförmig aus der Ebene der Leiterfolie abdrängenden Längsrippe bekannt, an der sich der Laschenansatz beim Aufstecken des Kontaktsteckers anschmiegt (EP-A-O 284 855). Da die Federleiste des Kontaktsteckers gegen das freie Ende des Laschenansatzes aufgesteckt wird, besteht die nicht geringe Gefahr, daß es zu einer Verkantung zwischen Stecker und dem freien Laschenende kommen kann.

Der vorliegenden Erfindung liegt nun die Aufgabe zugrunde, für die Kontaktierung einer Leiterfolie mit einem Stecker eine möglichst einfache, sichere und eventuelle Verkantungen verhindernde Vorrichtung zu schaffen.

Die Lösung dieser Aufgabe ergibt sich erfindungsgemäß durch die Merkmale des Anspruchs 1. Vorteilhafte Weiterbildungen der Erfindung sind in den Unteransprüchen angegeben.

Im folgenden wird ein Ausführungsbeispiel der Erfindung anhand der Zeichnung näher erläutert. Dabei zeigen:
Figur 1 eine Kontaktiervorrichtung gemäß der Erfindung in einer Schnittdarstellung am Beispiel einer Tastatur-Schaltfolie,
Figur 2 eine vergrößerte Darstellung der Kontaktiervorrichtung gemäß Figur 1.

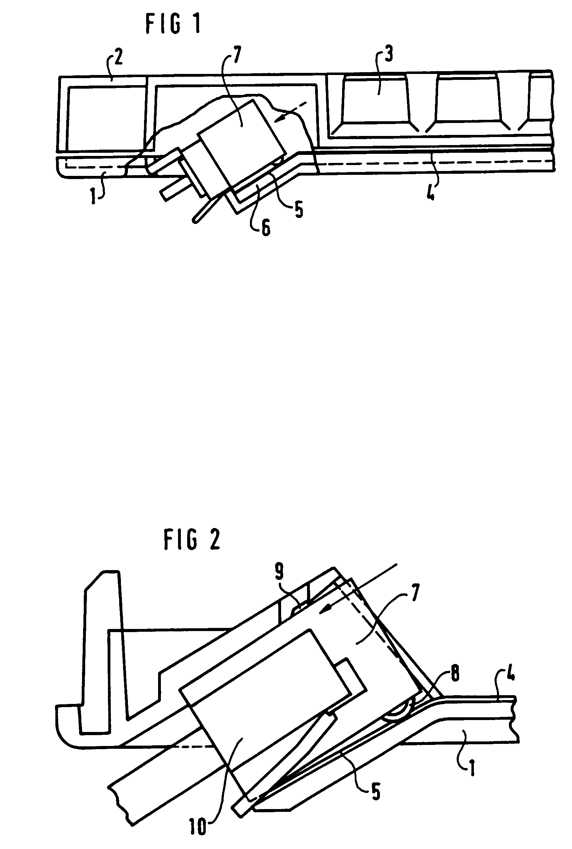

Die Figur 1 zeigt eine Schnittdarstellung eines Tastaturgehäuses mit einem als Bodenplatte 1 ausgebildeten Gehäuseunterteil und einem Gehäuseoberteil mit mehreren in Reihe angeordneten, jeweils einer Drucktaste zugeordneten Domen 3. Die Bodenplatte 1 dient als Trägerfläche für eine Tastaturschaltfolie 4. Diese im wesentlichen rechteckförmige Tastaturschaltfolie 4 weist an einer Kante, vorzugsweise an der der Gehäuserückwand zugekehrten Kante,einen Laschenansatz 5 auf, an den mehrere parallel verlaufende Kontaktleiterbahnen in Richtung freies Laschenende zur Verbindung mit einer Steckvorrichtung herausgeführt sind. An der Kontaktstelle zur Steckverbindung weist die Bodenfläche 1 einen schräg nach unten gerichteten offenen Schacht 6 auf, auf dessen nach unten abfallender Bodenfläche der Laschenansatz 5 mit den nach oben freiliegenden Kontaktleiterbahnen aufliegt. In diesen Schacht 6 wird nun eine Steckerbuchse 7 in Richtung des freien Laschenendes (siehe Pfeil) eingeschoben,wobei die Steckerbuchse 7 nach unten herausgeführte, bogenförmig vorgespannte Kontaktfederelemente aufweist, die beim Einschieben der Steckerbuchse 7 auf den Kontaktleiterbahnen der Tastaturschaltfolie 4 aufliegen. In der Endstellung wird die Steckerbuchse 7 entweder durch einen Anschlag oder durch Rastelemente im Schacht 6 fixiert.

Die Figur 2 zeigt die Kontaktiervorrichtung gemäß Figur 1 in etwas vergrößerter Darstellung. Sie zeigt den in der Bodenplatte 1 des Tastaturgehäuses schräg nach unten gerichteten Schacht 6, an dessen Bodenfläche der mehrere Kontaktleiterbahnen aufweisende Laschenansatz 5 der Tastaturschaltfolie 4 aufliegt. In diesen Schacht 6 wird die Steckerbuchse 7 in Pfeilrichtung eingeschoben, wobei die nach unten herausgeführten Kontaktfederelemente 8 jeweils federnd an den Kontaktleiterbahnen des Laschenansatzes 5 aufliegen. In eingestecktem Zustand wird die Steckerbuchse entweder durch einen Anschlag oder durch ein oder mehrere Rastelemente 9 im Schacht 6 fixiert. Zur spielfreien und formschlüssigen Befestigung der eine quaderähnliche Form aufweisenden Steckerbuchse sind an den Innenwandungen des Schachtes 6 und/oder an den räumlich zugeordneten Außenwandungen der Steckerbuchse 7 eine oder mehrere Verdrängungsrippen vorgesehen. Der zugehörige Stecker 10 für die Steckerbuchse 7 wird von außen über das nach unten offene Ende des Schachtes 6 eingesteckt. Der an der Gehäuseunterseite schräg nach unten herausgeführte Steckeranschluß hat gegenüber einer Steckeranordnung an der Gehäuserückwand den Vorteil, daß das Tastaturgehäuse sehr dicht vor einem Rechnergehäuse oder vor einer sonstigen Begrenzungswand aufgestellt werden kann.

## Patentansprüche

1. Kontaktiervorrichtung zum Anschluß einer mehrere Kontaktleiterbahnen aufweisenden, auf einer Trägerfläche aufliegenden Leiterfolie (4), wobei die Kontaktleiterbahnen an einem Laschenansatz der Leiterfolie parallel zueinander verlaufend angeordnet sind, unter Verwendung einer Steckerbuchse (7) mit mehreren, die Verbindung zu den Kontaktleiterbahnen herstellenden Kontaktfederelementen (8),
**dadurch gekennzeichnet,**
daß an der Trägerfläche ein den Außenabmessungen der Steckerbuchse (7) angepaßter offener Schacht (6) vorgesehen ist, daß der Laschenansatz (5) mit den nach oben freiliegenden Kontaktleiterbahnen auf der Bodenfläche des Schachtes (6) aufliegt und daß die Steckerbuchse (7) mit ihren nach außen geführten, der Bodenfläche des Schachtes zugewandten Kontaktfederelementen (8) in Richtung des freien Laschenendes in den Schacht (6) einführbar und in der Endstellung rastend befestigt ist.

2. Kontaktiervorrichtung nach Anspruch 1,
**dadurch gekennzeichnet,**
daß der Schacht (6) in einem spitzen Winkel zur Trägerfläche schräg nach unten verlaufend angeordnet ist.

3. Kontaktiervorrichtung nach Anspruch 1 oder 2,
**dadurch gekennzeichnet**,
daß die nach außen geführten Enden der Kontaktfederelemente (8) als bogenförmig vorgespannte Schleifkontakte ausgebildet sind.

4. Kontaktiervorrichtung nach einem der vorhergehenden Ansprüche,
**dadurch gekennzeichnet**,
daß die Steckerbuchse (7) eine quaderähnliche Form aufweist und daß an den Innenwandungen des Schachtes (6) und/oder an den räumlich zugeordneten Außenwandungen der Steckerbuchse (7) zur spielfreien und formschlüssigen Befestigung der Steckerbuchse (6) wenigstens eine Verdrängungsrippe vorgesehen ist.

5. Kontaktiervorrichtung nach Anspruch 4,
**dadurch gekennzeichnet,**
daß die Steckerbuchse wenigstens eine Rastnase aufweist, die in montiertem Zustand der Steckerbuchse in eine Vertiefung in der räumlich zugeordneten Schachtwandung eintaucht.

## Claims

1. Contact-making device for connecting a conductor film (4) which has a plurality of contact conductor tracks and rests on a base, the contact conductor tracks being arranged on a tab attachment of the conductor film so as to run parallel to each other, by using a plug socket (7) which has a plurality of contact spring elements (8) making the contact with the contact conductor tracks, characterized in that an open shaft (6) which is matched to the outer dimensions of the plug socket (7) is provided on the base, in that the tab attachment (5), together with the contact conductor tracks which are free at the top, comes to rest on the bottom surface of the shaft (6), and in that the plug socket (7), together with its contact spring elements (8) passed outwards and facing the bottom surface of the shaft, can be inserted into the shaft (6) in the direction of the free tab end and is fastened in the end position in a locking manner.

2. Contact-making device according to Claim 1, characterized in that the shaft (6) is arranged so as to run obliquely downwards at an acute angle with respect to the base.

3. Contact-making device according to Claim 1 or 2, characterized in that the ends of the contact spring elements (8), which are passed outwards, are constructed as sliding contacts biased in an arc-shaped manner.

4. Contact-making device according to any one of the preceding claims, characterized in that the plug socket (7) has a box-like shape and in that at least one displacement rib is provided on the inner walls of the shaft (6) and/or on the spatially assigned outer walls of the plug socket (7) for fastening the plug socket (7) in a play-free and positively locking manner.

5. Contact-making device according to Claim 4, characterized in that the plug socket has at least one locking stud which in the assembled state of the plug socket dips into a depression in the spatially assigned shaft wall.

## Revendications

1. Dispositif de contact pour le raccordement d'un ruban (4) conducteur, comportant plusieurs pistes conductrices de contact et appliqué sur une surface de support, les pistes conductrices de contact étant disposées sur le bout d'une languette du ruban conducteur en s'étendant parallèlement entre elles, moyennant l'utilisation d'une douille (7) comportant plusieurs éléments (8) de ressort de contact établissant la liaison avec les pistes conductrices de contact,
caractérisé en ce que il est prévu sur la surface de support un puits (6) adapté aux dimensions extérieures de la douille (7) et béant, le bout (5) de la languette appuie, par les pistes conductrices de contact mises à nu vers le haut, sur la surface du fond du puits (6) et la douille (7) peut être introduite par ces éléments (8) de ressort de contact menant vers l'extérieur et tournés vers la surface de fond du puits, en direction de l'extrémité libre de la languette dans le puits (6) et est fixée par encliquetage dans la position d'extrémité.

2. Dispositif de contact suivant la revendication 1, caractérisé en ce que
le puits (6) s'étend en oblique vers le bas en faisant un angle aigu par rapport à la surface de support.

3. Dispositif de contact suivant la revendication 1 ou 2, caractérisé en ce que
les extrémités menant à l'extérieur des éléments (8) de ressort de contact sont sous forme de contacts par frottement précontraints en arc.

4. Dispositif de contact suivant l'une des revendications précédentes,
caractérisé en ce que
la douille (7) a une forme parallélépipédique et il est prévu sur les parois intérieures du puits (6) et/ou sur les parois extérieures de la douille (7) qui leur sont associées dans l'espace, pour la fixation sans jeu et par complémentarité de forme de la douille (6), au moins une nervure de refoulement.

5. Dispositif de contact suivant la revendication 4,
caractérisé en ce que
la douille comporte au moins un bec d'encliquetage, qui, lorsque la douille est montée, pénètre dans un renfoncement de la paroi du puits associée dans l'espace.
